# EUROPÄISCHE PATENTSCHRIFT

(11) **EP 2 888 053 B1**
(45) Veröffentlichungstag und Bekanntmachung des Hinweises auf die Patenterteilung: **27.07.2016**
(21) Anmeldenummer: 12766850.7
(22) Anmeldetag: 24.08.2012
(51) Int. Cl.: B02C 19/18

(54) **VERFAHREN UND VORRICHTUNG ZUR FRAGMENTIERUNG UND/ODER SCHWÄCHUNG VON MATERIAL MITTELS HOCHSPANNUNGSPULSEN**
METHOD AND DEVICE FOR FRAGMENTING AND/OR WEAKENING MATERIAL BY MEANS OF HIGH-VOLTAGE PULSES
PROCEDE ET DISPOSITIF DE FRAGMENTATION ET/OU D'AFFAIBLISSEMENT DE MATERIAU AU MOYEN D'IMPULSIONS A HAUTE TENSION

(43) Veröffentlichungstag der Anmeldung: 01.07.2015
(73) Patentinhaber: selFrag AG, 3210 Kerzers (CH)
(72) Erfinder: MÜLLER-SIEBERT, Reinhard, 3013 Bern (CH); MONTI DI SOPRA, Fabrice, 3604 Thun (CH); GIESE, Harald, 76297 Stutensee (DE); FRIEDLI, Urs, 3018 Bern (CH)
(74) Vertreter: Münch, Martin Walter
(86) Internationale Anmeldenummer: PCT/CH2012/000203
(87) Internationale Veröffentlichungsnummer: WO 2014/029034

(56) Entgegenhaltungen:
- WO-A1-2007/093063
- US-A- 4 540 127

## Beschreibung

### TECHNISCHES GEBIET

Die Erfindung betrifft ein Verfahren zur Fragmentierung und/oder Schwächung von Material mittels Hochspannungspulsen, eine Elektrode zur Verwendung in dem Verfahren, eine Vorrichtung zum Fragmentieren und/oder Schwächen von Material mittels Hochspannungspulsen insbesondere nach dem Verfahren sowie die Verwendung der Elektrode oder der Vorrichtung zum Fragmentieren und/oder Schwächen von Material gemäss den Oberbegriffen der unabhängigen Patentansprüche.

### STAND DER TECHNIK

Aus dem Stand der Technik ist es bekannt, verschiedenste Materialien, wie z.B. Beton oder Gestein, mittels gepulster Hochspannungsentladungen zu zerkleinern oder zu schwächen, z.B. derartig mit Rissen zu versehen, dass diese in einem nachgeschalteten mechanischen Zerkleinerungsprozess einfacher zerkleinert werden können.

Hierzu wird das zu zerkleinernde bzw. zu schwächende Material zusammen mit einer Prozessflüssigkeit, beispielsweise Wasser, in einen Bereich eingebracht, in welchem zwischen zwei Elektroden Hochspannungsdurchschläge erzeugt werden. Um einen Durchschlag zu erzeugen, werden die Elektroden mit einem Hochspannungspuls beaufschlagt. Dabei wird eine endliche Zeit benötigt, damit Vorentladungskanäle die Prozessflüssigkeits und Materialstrecken überbrücken können und ein durchgehender Plasmakanal entsteht, welcher dann zu einem Durchschlag führt. Innerhalb dieser Zeit fliesst über die Prozessflüssigkeit, welche eine gewisse elektrische Leitfähigkeit aufweist, die mit zunehmender Betriebszeit ansteigen kann, ein Strom zwischen den Elektroden, wodurch die Spannung zwischen diesen infolge der Entladung des die Energie zur Verfügung stellenden Energiespeichers kontinuierlich abnimmt. Der in der Zeit bis zum Durchschlag fliessende Strom leistet keine Fragmentierungs- oder Schwächungsarbeit, sondern erwärmt lediglich die Prozessflüssigkeit. Er stellt daher einen Verlust dar, welcher den energetischen Wirkungsgrad des Prozesses verschlechtert. Ein permanenter Austausch bzw. eine kontinuierliche aufwendige Aufbereitung der Prozessflüssigkeit zwecks Erhaltung bzw. Reduzierung der elektrischen Leitfähigkeit reduziert ebenfalls die Effizienz des Prozesses. Fällt die Spannung bereits während der Ausbildung der Vorentladungskanäle unter die Durchschlagspannung, wachsen die Vorentladungskanäle nicht mehr weiter und "sterben" ab. Ein Durchschlag oder durchgehender Plasmakanal tritt in diesem Fall nicht auf, und die gesamte zugeführte Energie ist für den Fragmentierungs- bzw. Schwächungsprozess verloren.

Bei bestimmten Anwendungen kann es auch gewünscht sein, zur schonenden Vorschwächung des Materials keine Durchschläge sondern lediglich Vorentladungskanäle zu erzeugen. In diesem Fall ist es jedoch ebenfalls wünschenswert, dass ein möglichst kleiner Anteil der zugeführten Energie der Erwärmung der Prozessflüssigkeit dient und ein möglichst grosser Anteil der Bildung von Vorentladungskanälen.

Aus WO 2007/093063 A1 sind Arbeitselektroden für elektrodynamische Fragmentierungsanlagen bekannt, bei denen die Elektrodenspitze von einem austauschbaren Wechselteil gebildet wird.

Aus US 4,540,127 A ist eine elektrodynamische Fragmentierungsanlage für diamantenhaltiges Gesteinsmaterial bekannt, bei der die Hochspannungselektrode, mit Ausnahme ihrer Spitze, von einer Isolationshülle umgeben ist.

### DARSTELLUNG DER ERFINDUNG

Es stellt sich die Aufgabe, Verfahren und Vorrichtungen zur Fragmentierung bzw. Schwächung von Materialien mittels Hochspannungsimpulsen zur Verfügung zu stellen, welche einen möglichst guten energetischen Wirkungsgrad aufweisen und tolerant sind gegenüber einer Leitfähigkeitszunahme der Prozessflüssigkeit.

Diese Aufgabe wird von den Gegenständen der unabhängigen Patentansprüche gelöst.

Gemäss diesen betrifft ein erster Aspekt der Erfindung ein Verfahren zur Fragmentierung und/oder Schwächung von Material, bevorzugterweise von Gesteinsmaterial oder Erz, mittels Hochspannungspulsen.

Unter einer Fragmentierung wird eine Zerkleinerung des Materials verstanden. Unter einer Schwächung (auch als Vorschwächung bezeichnet) wird eine Erzeugung von internen Rissen im Material verstanden, welche eine weitere insbesondere mechanische Zerkleinerung des Materials erleichtert.

Dabei wird das zu fragmentierende und/oder zu schwächende Material zusammen mit einer Prozessflüssigkeit in einer zwischen zwei Elektroden gebildeten offenen oder geschlossenen Prozesszone angeordnet, derart, dass die gesamte Prozesszone mit Prozessflüssigkeit geflutet ist, die Elektroden also beide mit der Prozessflüssigkeit in Kontakt stehen und das zwischen den beiden Elektroden angeordnete zu fragmentierende oder zu schwächende Material vollständig in Prozessflüssigkeit eingetaucht ist. In diesem Zustand werden die Elektroden mit Hochspannungspulsen beaufschlagt, so dass es zwischen diesen zu Hochspannungsdurchschlägen kommt, oder lediglich zur Bildung von Vorentladungskanälen ohne Hochspannungsdurchschläge, z.B. wenn solche unerwünscht sind.

Erfindungsgemäss kommt dabei für zumindest eine der beiden Elektroden eine anspruchsgemässe erste Elektrode zum Einsatz, welche einen metallischen Leiter aufweist, der am Arbeitsende der Elektrode, welches mit der Prozessflüssigkeit in Kontakt steht, teilweise oder vollständig mit einer anspruchsgemässen ersten Isolierung bzw. Isolationsbeschichtung versehen ist, welche eine Permittivität aufweist, die mindestens 75% der Permittivität der Prozessflüssigkeit beträgt. Bevorzugterweise kommt Wasser als Prozessflüssigkeit zum Einsatz, welches typischerweise eine Permittivität von etwa 80 aufweist.

Überraschenderweise hat sich gezeigt, dass sich durch Verwendung einer derartigen erfindungsgemässen Elektrode der energetischen Wirkungsgrad von gattungsgemässen Verfahren zur Fragmentierung und/oder Schwächung von Material mittels Hochspannungspulsen deutlich verbessern lässt und zudem eine erhöhte Toleranz bezüglich einer Zunahme der Leitfähigkeit der Prozessflüssigkeit erreicht werden kann.

Bevorzugterweise wird eine anspruchsgemässe erste Elektrode verwendet, deren anspruchsgemässe erste Isolierung bzw. Isolationsbeschichtung eine Permittivität grösser als 50, bevorzugterweise grösser als 80 aufweist.

Dabei ist es weiter bevorzugt, dass die Permittivität der ersten Isolierung bzw. Isolationsbeschichtung zwischen 60 und 100, insbesondere zwischen 75 und 85 ist.

Die Verwendung von Elektroden mit derartigen ersten Isolierungen bzw. Isolationsbeschichtungen ist besonders vorteilhaft in Verfahren, bei denen Wasser als Prozessflüssigkeit zum Einsatz kommt.

In einer bevorzugten Ausführungsform des Verfahrens wird eine anspruchsgemässe erste Elektrode verwendet, deren metallischer Leiter am Arbeitsende der Elektrode, welches mit der Prozessflüssigkeit in Kontakt steht, neben der anspruchsgemässen ersten Isolierung bzw. Isolationsbeschichtung eine anspruchsgemässe zweite Isolierung bzw. Isolationsbeschichtung aufweist, welche eine Permittivität kleiner 50% der Permittivität der Prozessflüssigkeit besitzt, insbesondere eine Permittivität zwischen 2 und 10. Bereiche der Elektrode, die mit dieser zweiten Isolierung bzw. Isolationsbeschichtung versehen sind, eignen sich besonders gut zur mechanischen Ankopplung der Elektrode an eine Tragstruktur.

Dabei ist es bevorzugt, dass eine anspruchsgemässe erste Elektrode verwendet wird, bei welcher die erste Isolierung bzw. Isolationsbeschichtung und die zweite Isolierung bzw. Isolationsbeschichtung direkt aneinander angrenzen, ineinander übergehen oder einander durchdringen, so dass diese eine zusammenhängende und bevorzugterweise geschlossene Isolationsfläche bilden. Hierdurch lassen sich Zonen mit sehr starken elektrischen Feldern gezielt in diejenigen Bereiche der jeweiligen Elektrodenkontur verlegen, in denen diese Zwecks Erzeugung von Vorentladungskanälen und gegebenenfalls Hochspannungsdurchschlägen gewünscht sind.

Weiter ist es dabei bevorzugt, dass die Permittivität der von der ersten Isolierung bzw. Isolationsbeschichtung und der zweiten Isolierung bzw. Isolationsbeschichtung gebildeten Isolationsfläche in Richtung vom Arbeitsende wegzeigend abnehmend ist, die Isolationsfläche also in dem Bereich, welcher dem freien Ende des Arbeitsendes der Elektrode am nächsten liegt, die höchste Permittivität aufweist und in dem diesem freien Ende entferntesten Bereich die geringste Permittivität aufweist. Dabei ist es bevorzugt, dass die Abnahme der Permittivität zumindest bereichsweise stufenlos erfolgt, was z.B. dadurch erreicht werden kann, dass sich die Isolierungen bzw. Isolationsbeschichtungen über einen bestimmten Bereich durchdringen oder ineinander übergehen. Hierdurch lassen sich abrupte Feldänderungen vermeiden.

In einer weiteren bevorzugten Ausführungsform des Verfahrens wird die Prozesszone zwischen zwei mit einem Abstand übereinander angeordneten Elektroden gebildet, derart, dass das in der Prozesszone angeordnete zu fragmentierende und/oder zu schwächende Material auf der unteren Elektrode aufliegt. Zumindest für die obere Elektrode wird bevorzugterweise eine anspruchsgemässe erste Elektrode verwendet. Eine derartige Elektrodenanordnung hat sich als besonders vorteilhaft erwiesen und bietet bei Ausbildung der oberen Elektrode als anspruchsgemässe erste Elektrode zudem den Vorteil, dass deren erste und/- oder zweite Isolierung bzw. Isolationsbeschichtung mechanisch nur sehr wenig durch das zu fragmentierende und/- oder zu schwächende Material beansprucht wird.

In weiteren bevorzugten Ausführungsformen wird das Verfahren in einer geschlossenen Prozesszone, bevorzugterweise in einem geschlossenen Prozessgefäss, durchgeführt, oder in einer offenen Prozesszone. Erstgenannte Variante eignet sich vor allem für einen batchweisen Betrieb, während letztgenannte Varianten bei einem kontinuierlichen Betrieb zu bevorzugen ist. Dabei wird im letztgenannten Fall bevorzugterweise als untere Elektrode eine Förderbandelektrode verwendet, mit welcher das zu fragmentierende und/oder zu schwächende Material in die Prozesszone geführt und nach der Einwirkung darauf aus der Prozesszone entfernt werden kann.

Ein zweiter Aspekt der Erfindung betrifft eine Elektrode zur Verwendung im Verfahren gemäss dem ersten Aspekt der Erfindung.

Die Elektrode umfasst einen metallischen Leiter, z.B. aus Kupfer oder Edelstahl, der am Arbeitsende der Elektrode, d.h. an dem Ende der Elektrode, welches bei bestimmungsgemässer Verwendung derselben mit der Prozessflüssigkeit in Kontakt steht, teilweise oder vollständig mit einer anspruchsgemässen ersten Isolierung oder Isolationsbeschichtung versehen ist. Diese Isolierung oder Isolationsbeschichtung weist eine Permittivität grösser 50, bevorzugterweise grösser 80 auf.

Mit derartigen erfindungsgemässen Elektroden lässt sich der energetischen Wirkungsgrad von bekannten Verfahren zur Fragmentierung und/oder Schwächung von Material mittels Hochspannungspulsen deutlich verbessern und es kann zudem eine erhöhte Toleranz bezüglich einer Zunahme der Leitfähigkeit der Prozessflüssigkeit erreicht werden.

Die anspruchsgemässe erste Isolierung bzw. Isolationsbeschichtung weist bevorzugterweise eine Permittivität zwischen 60 und 100 auf, noch bevorzugter zwischen 75 und 85. Elektroden mit derartigen ersten Isolierungen bzw. Isolationsbeschichtungen eignen sich besonders gut für den Einsatz in Verfahren, bei denen Wasser als Prozessflüssigkeit verwendet wird.

In einer bevorzugten Ausführungsform der Elektrode weist deren metallischer Leiter am Arbeitsende der Elektrode neben der anspruchsgemässen ersten Isolierung oder Isolationsbeschichtung eine anspruchsgemässe zweite Isolierung oder Isolationsbeschichtung auf, welche eine Permittivität kleiner 50 besitzt, insbesondere eine Permittivität zwischen 2 und 10. Bereiche, die mit dieser zweiten Isolierung bzw. Isolationsbeschichtung versehen sind, eignen sich besonders gut zur mechanischen Ankopplung der Elektrode an eine Tragstruktur.

Dabei ist es bevorzugt, dass die anspruchsgemässe erste Isolierung bzw. Isolationsbeschichtung und die anspruchsgemässe zweite Isolierung bzw. Isolationsbeschichtung direkt aneinander angrenzen, ineinander übergehen oder einander durchdringen, derart, dass diese eine zusammenhängende, mit Vorteil geschlossene Isolationsfläche bilden. Hierdurch lassen sich mögliche Entladungszonen zwischen den Isolierungen bzw. Isolationsbeschichtungen vermeiden.

Bei dieser Ausführungsform ist es bevorzugt, dass die Permittivität der von der ersten Isolierung bzw. Isolationsbeschichtung und der zweiten Isolierung bzw. Isolationsbeschichtung gebildeten Isolationsfläche in Richtung vom Arbeitsende wegzeigend abnehmend ist, diese Isolationsfläche also in dem Bereich, welcher dem freien Ende des Arbeitsendes der Elektrode am nächsten liegt, die höchste Permittivität aufweist und in dem diesem freien Ende entferntest gelegenen Bereich die geringste Permittivität aufweist. Dabei ist es weiter bevorzugt, dass die Abnahme der Permittivität zumindest bereichsweise stufenlos erfolgt. Hierdurch lassen sich abrupte Feldänderungen vermeiden.

In noch einer weiteren bevorzugten Ausführungsform der Elektrode bildet der metallische Leiter am Arbeitsende der Elektrode einen ringförmigen Bereich mit gerundetem Rand. Im bestimmungsgemässen Betrieb der Elektrode dient dieser ringförmige Bereich als Feldentlastung.

Dabei kann der ringförmige Bereich elektrisch leitend mit dem metallischen Leiter verbunden sein, z.B. indem er einstückig mit diesem ausgebildet ist, oder er kann durch die erste Isolierung bzw. Isolationsbeschichtung vom metallischen Leiter getrennt und damit elektrisch von diesem isoliert sein. Die Funktion als Feldentlastung wird hierdurch nur unwesentlich beeinflusst.

Mit Vorteil ist der ringförmige Bereich zumindest auf seinen vom Arbeitsende der Elektrode wegzeigenden Flächen mit der ersten Isolierung bzw. Isolationsbeschichtung versehen, insbesondere dann, wenn er elektrisch leitend mit dem metallischen Leiter verbunden ist. Hierdurch lässt sich die elektrisch leitende Fläche der Elektrode deutlich herabsetzen.

In einer Variante der zuvor beschriebenen Elektrode bildet der ringförmige Bereich das arbeitsendseitige Ende der Elektrode. Auf diese Weise ergibt sich eine stumpfe Elektrode mit einer grossen, z.B. tellerförmigen Stirnfläche.

In einer anderen Variante der Elektrode schliesst an den ringförmigen Bereich eine bevorzugterweise kugelkalottenförmige oder rotationsparaboloidförmige Elektrodenspitze an, welche das arbeitsendseitige Ende der Elektrode bildet. Bevorzugterweise ist diese Elektrodenspitze an ihrem freien Ende metallisch blank. Auf diese Weise ergibt sich eine relativ spitze Elektrode mit einer kleinen Stirnfläche.

Je nach Einsatzgebiet der Elektrode ist die eine oder die andere Variante zu bevorzugen.

In noch einer weiteren bevorzugten Ausführungsform weist die Elektrode einen Isolatorkörper aus einem Material mit einer Permittivität kleiner 20 auf, z.B. aus PE oder PP, aus welchem am Arbeitsende der metallische Leiter heraussteht. Dieser Isolatorkörper kann eine anspruchsgemässe zweite Isolierung bilden oder auch zusätzlich zu einer anderen anspruchsgemässen zweiten Isolierung oder Isolationsbeschichtung vorhanden sein. Derartige Elektroden lassen sich auf einfache Weise mit Hilfe des Isolatorkörpers elektrisch isoliert an einer Tragstruktur befestigen.

In einer Ausführungsvariante dieser Ausführungsform der Elektrode ist der Isolatorkörper von einem oder mehreren konzentrisch zu dem in dessen Zentrum verlaufenden metallischen Leiter verlaufenden ringförmigen Elementen aus einem Material mit einer höheren Permittivität als das Material des Isolators, z.B. aus einem metallischen Werkstoff, wie z.B. Edelstahl, oder aus einem graphitdurchsetzten Kunststoff, durchsetzt. Auf diese Weise kann der über das Volumen des Isolatorkörpers in diesem Bereich gemittelte Permittivitätsverlauf gezielt beeinflusst werden.

Weiter ist es bei Ausführungsformen der Elektrode mit einem Isolatorkörper bevorzugt, dass der metallische Leiter in dem Bereich, in welchem er aus dem Isolatorkörper austritt, mit der ersten oder der zweiten Isolierung bzw. Isolationsbeschichtung versehen ist. Insbesondere für den Fall, dass er an dieser Stelle mit der zweiten Isolierung bzw. Isolationsbeschichtung versehen ist, ergibt sich ein relativ sanfter Übergang bezüglich der elektrischen Feldstärken vom Isolatorkörper auf den metallischen Leiter.

Ein dritter Aspekt der Erfindung betrifft eine Vorrichtung zum Fragmentieren und/oder Schwächen von Material, bevorzugterweise von Gesteinsmaterial oder Erz, mittels Hochspannungspulsen. Mit Vorteil ist diese Vorrichtung geeignet zur Durchführung des Verfahrens gemäss dem ersten Aspekt der Erfindung.

Die Vorrichtung umfasst zwei Elektroden, von denen eine oder beide als Elektrode gemäss dem zweiten Aspekt der Erfindung ausgebildet ist oder sind. Zwischen den beiden Elektroden ist eine Prozesszone gebildet, in welcher das zu fragmentierende und/oder zu schwächende Material und eine Prozessflüssigkeit angeordnet werden können, derart, dass die gesamte Prozesszone mit Prozessflüssigkeit geflutet ist. In diesem Zustand können die Elektroden mit Hochspannungspulsen beaufschlagt werden, derart, dass es zwischen den beiden Elektroden zu Hochspannungsdurchschlägen kommt und/oder dass es zur Bildung von Vorentladungskanälen ohne Durchschläge kommt.

In einer bevorzugten Ausführungsform der Vorrichtung sind die beiden Elektroden übereinander angeordnet, derart, dass das zu fragmentierende und/oder zu schwächende Material bei befüllter Prozesszone auf der unteren Elektrode aufliegt. Mit Vorteil ist dabei zumindest die obere Elektrode eine Elektrode gemäss dem zweiten Aspekt der Erfindung. Eine derartige Anordnung der Elektroden hat sich als besonders vorteilhaft erwiesen und bietet bei Ausbildung der oberen Elektrode als anspruchsgemässe erste Elektrode zudem den Vorteil, dass deren erste und/oder zweite Isolierung bzw. Isolationsbeschichtung mechanisch nur sehr wenig durch das zu fragmentierende und/oder zu schwächende Material beansprucht wird.

In weiteren bevorzugten Ausführungsformen weist die Vorrichtung entweder eine geschlossene bzw. schliessbare Prozesszone auf, welche bevorzugterweise von einem geschlossenen Prozessgefäss gebildet ist, oder eine offene Prozesszone. Erstgenannte Variante eignet sich vor allem für einen Batchbetrieb, während letztgenannte Varianten bei einem kontinuierlichen Betrieb zu bevorzugen ist. Dabei ist im letztgenannten Fall die untere Elektrode bevorzugterweise als Förderbandelektrode ausgebildet, mit welcher das zu fragmentierende und/oder zu schwächende Material in die Prozesszone geführt und nach der Einwirkung darauf aus der Prozesszone entfernt werden kann.

### KURZE BESCHREIBUNG DER ZEICHNUNGEN

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 einen Vertikalschnitt durch eine Hälfte des Arbeitsendes einer ersten erfindungsgemässen Elektrode;
Fig. 2 einen Vertikalschnitt durch eine Hälfte des Arbeitsendes einer zweiten erfindungsgemässen Elektrode;
Fig. 3 einen Vertikalschnitt durch eine Hälfte des Arbeitsendes einer dritten erfindungsgemässen Elektrode;
Fig. 4 einen Vertikalschnitt durch eine Hälfte des Arbeitsendes einer vierten erfindungsgemässen Elektrode;
Fig. 5 einen Vertikalschnitt durch eine Hälfte des Arbeitsendes einer fünften erfindungsgemässen Elektrode;
Fig. 6 einen Vertikalschnitt durch eine Hälfte des Arbeitsendes einer sechsten erfindungsgemässen Elektrode;
Fig. 7 einen Vertikalschnitt durch eine Hälfte des Arbeitsendes einer siebten erfindungsgemässen Elektrode;
Fig. 8 einen Vertikalschnitt durch eine Hälfte des Arbeitsendes einer achten erfindungsgemässen Elektrode;
Fig. 9 einen Vertikalschnitt durch eine Hälfte des Arbeitsendes einer neunten erfindungsgemässen Elektrode;
Fig. 10 einen Vertikalschnitt durch eine Hälfte des Arbeitsendes einer zehnten erfindungsgemässen Elektrode;
Fig. 11 einen Vertikalschnitt durch eine Hälfte des Arbeitsendes einer elften erfindungsgemässen Elektrode;
Fig. 12 einen Vertikalschnitt durch eine Hälfte des Arbeitsendes einer zwölften erfindungsgemässen Elektrode;
Fig. 13 einen Vertikalschnitt durch eine Hälfte des Arbeitsendes einer dreizehnten erfindungsgemässen Elektrode;
Fig. 14 einen Vertikalschnitt in Querrichtung durch eine Hälfte des Arbeitsendes einer vierzehnten erfindungsgemässen Elektrode;
Fig. 15 einen Vertikalschnitt in Längsrichtung durch eine Hälfte des Arbeitsendes der Elektrode aus Fig. 14;
Fig. 16 einen Vertikalschnitt in Längsrichtung durch eine Hälfte des Arbeitsendes einer fünfzehnten erfindungsgemässen Elektrode;
Fig. 17 einen Vertikalschnitt in Querrichtung durch eine Hälfte des Arbeitsendes der Elektrode aus Fig. 16;
Fig. 18 einen Vertikalschnitt durch eine Hälfte des Arbeitsendes einer sechzehnten erfindungsgemässen Elektrode; und
Fig. 19 eine Sicht auf eine Hälfte des Arbeitsendes der Elektrode aus Fig. 18.

### WEGE ZUR AUSFÜHRUNG DER ERFINDUNG

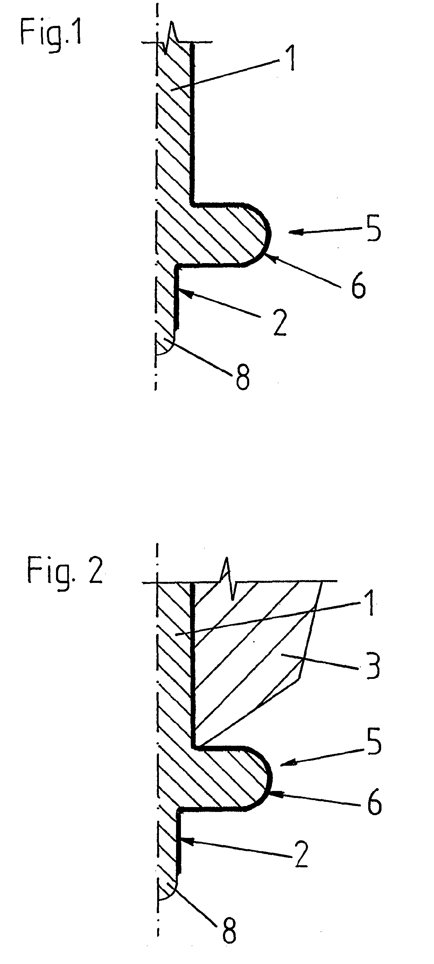

Fig. 1 zeigt einen Vertikalschnitt durch eine Hälfte des Arbeitsendes einer ersten erfindungsgemässen rotationssymmetrischen Elektrode. Wie zu erkennen ist, weist die Elektrode einen im Wesentlichen stabförmigen metallischen Leiter 1 auf, z.B. aus Kupfer oder Edelstahl, welcher am dargestellten Arbeitsende der Elektrode einen ringförmigen Bereich 5 mit gerundetem Rand 6 bildet, und im Anschluss an den ringförmigen Bereich 5 zum freien Ende der Elektrode in eine kugelkalottenförmige Elektrodenspitze 8 ausläuft, welche das arbeitsendseitige Ende der Elektrode darstellt. Der metallische Leiter 1 ist bis auf die eigentliche Elektrodenspitze 8 vollständig mit einer anspruchsgemässen ersten Isolationsbeschichtung 2 versehen, z.B. aus TiO2, welche eine Permittivität grösser 50 aufweist. Der ringförmigen Bereich 5 dient als Feldentlastung.

Fig. 2 zeigt einen Vertikalschnitt durch eine Hälfte des Arbeitsendes einer zweiten erfindungsgemässen Elektrode, welche sich von der in Fig. 1 dargestellten lediglich dadurch unterscheidet, dass der metallische Leiter 1 aus einem Isolatorkörper 3, aus einem Material mit einer Permittivität kleiner 20, z.B. aus PE oder PP, herausragt.

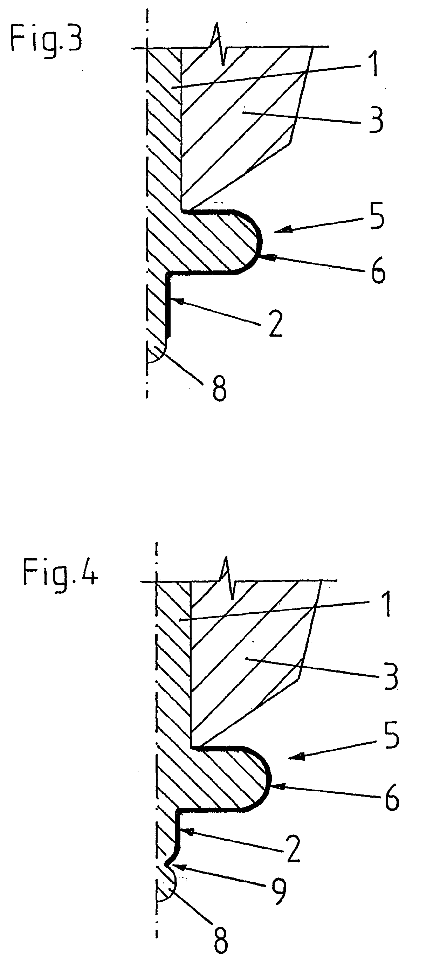

Fig. 3 zeigt einen Vertikalschnitt durch eine Hälfte des Arbeitsendes einer dritten erfindungsgemässen Elektrode, welche sich von der in Fig. 2 gezeigten Elektrode lediglich dadurch unterscheidet, dass der metallische Leiter 1 in dem Bereich, wo er von dem Isolatorkörper 3 umgeben ist, keine Isolationsbeschichtung aufweist.

Fig. 4 zeigt einen Vertikalschnitt durch eine Hälfte des Arbeitsendes einer vierten erfindungsgemässen Elektrode, welche sich von der in Fig. 3 gezeigten lediglich dadurch unterscheidet, dass die Elektrodenspitze 8 eine Eindrehung 9 aufweist, in welcher die Isolationsbeschichtung 2 endet.

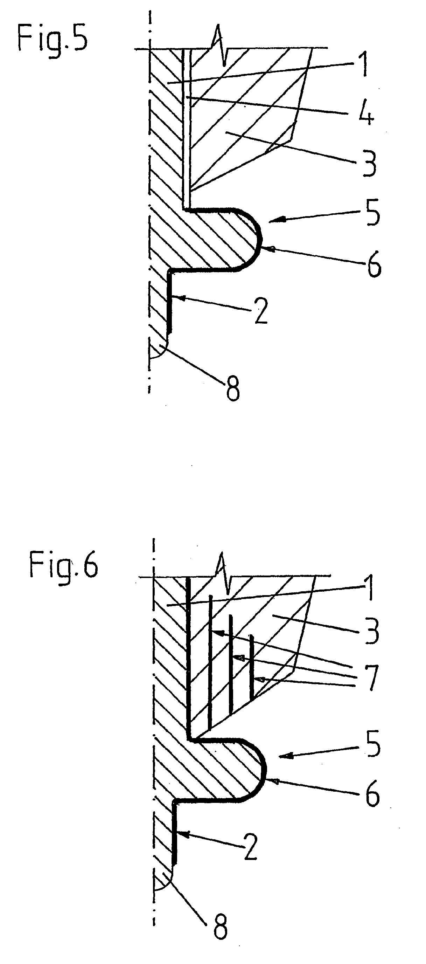

Fig. 5 zeigt einen Vertikalschnitt durch eine Hälfte des Arbeitsendes einer fünften erfindungsgemässen Elektrode, welche sich von der in Fig. 2 gezeigten lediglich dadurch unterscheidet, dass der metallische Leiter 1 in dem an die dem Arbeitsende abgewandte Seite des ringförmigen Bereichs 5 anschliessenden Bereich eine anspruchsgemässe zweite Isolationsbeschichtung 4 aufweist, z.B. aus PE, welche eine Permittivität kleiner 50 aufweist.

Fig. 6 zeigt einen Vertikalschnitt durch eine Hälfte des Arbeitsendes einer sechsten erfindungsgemässen Elektrode, welche sich von der in Fig. 2 gezeigten lediglich dadurch unterscheidet, dass der Isolatorkörper 3 von mehreren konzentrisch zu dem diesen durchdringenden metallischen Leiter 1 verlaufenden ringförmigen Elementen 7 aus einem Material mit einer höheren Permittivität als das Material des Isolators 3, z.B. aus Edelstahl oder aus einem mit Graphit durchsetzten Kunststoff, durchsetzt ist.

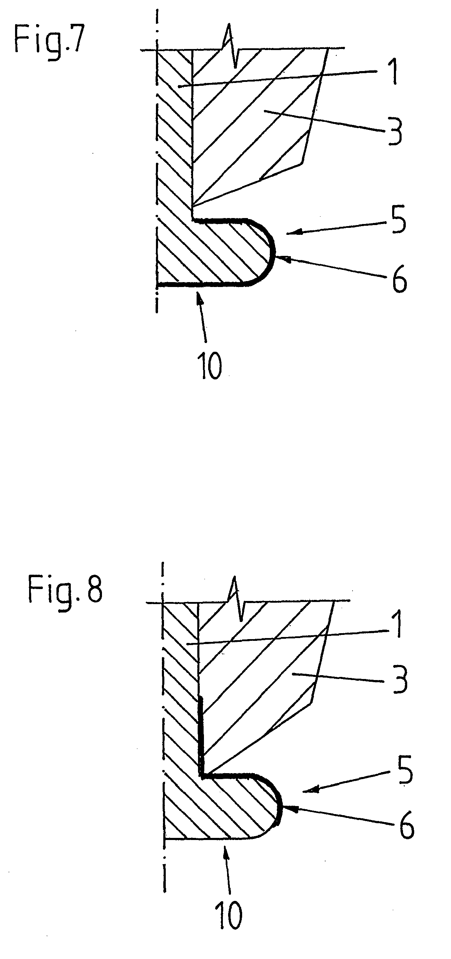

Fig. 7 zeigt einen Vertikalschnitt durch eine Hälfte des Arbeitsendes einer siebten erfindungsgemässen Elektrode, welche sich von den in den Figuren 3 und 4 dargestellten Elektroden lediglich dadurch unterscheidet, dass an den ringförmigen Bereich 5 keine das arbeitsendseitige Ende der Elektrode bildende Elektrodenspitze anschliesst, sondern der ringförmige Bereich 5 das arbeitsendseitige Ende der Elektrode bildet und seine Stirnfläche 10 vollständig mit der Isolationsbeschichtung 2 überzogen ist.

Fig. 8 zeigt einen Vertikalschnitt durch eine Hälfte des Arbeitsendes einer achten erfindungsgemässen Elektrode, welche sich von der in Fig. 7 gezeigten lediglich dadurch unterscheidet, dass die Stirnfläche 10 metallisch blank ist und sich die Isolationsbeschichtung 2 ein Stück weit bis in den Isolatorkörper 3 erstreckt.

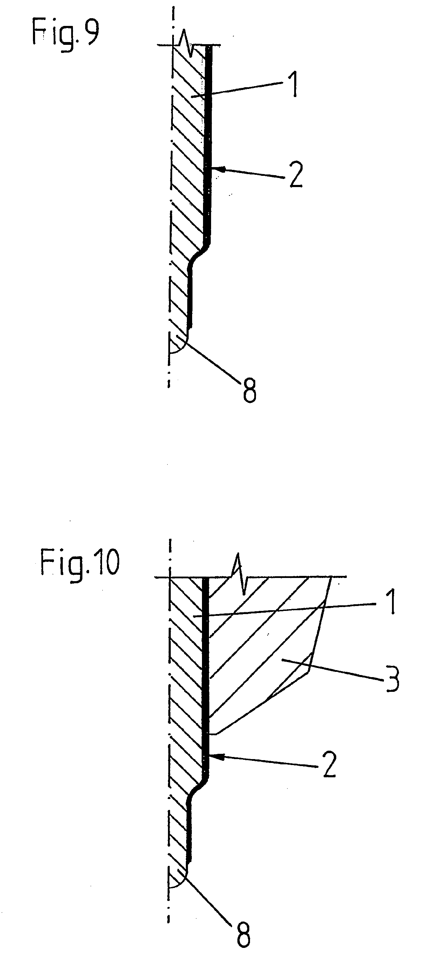

Fig. 9 zeigt einen Vertikalschnitt durch eine Hälfte des Arbeitsendes einer neunten erfindungsgemässen stabförmigen Elektrode, welche sich von der in Fig. 1 gezeigten lediglich dadurch unterscheidet, dass sie den dort vorhandenen ringförmigen Bereich nicht aufweist.

Fig. 10 zeigt einen Vertikalschnitt durch eine Hälfte des Arbeitsendes einer zehnten erfindungsgemässen Elektrode, welche sich von der in Fig. 9 gezeigten lediglich dadurch unterscheidet, dass der metallische Leiter 1 aus einem Isolatorkörper 3 aus einem Material mit einer Permittivität kleiner 20, z.B. aus PE oder PP, herausragt.

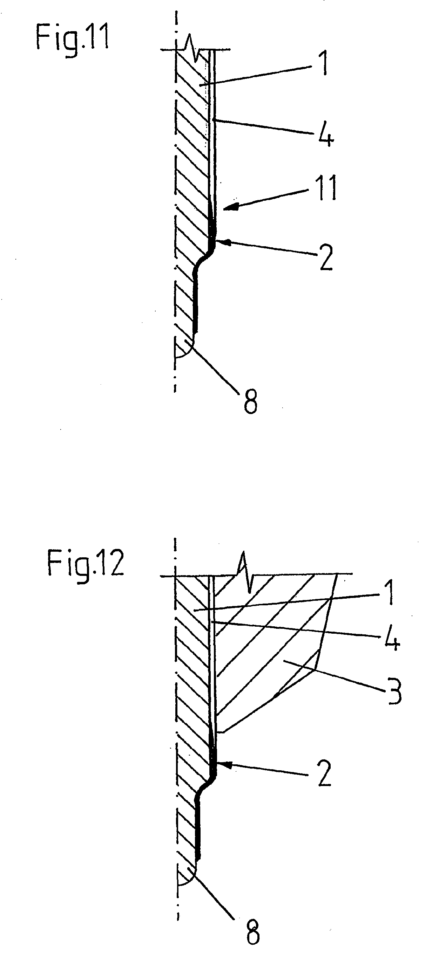

Fig. 11 zeigt einen Vertikalschnitt durch eine Hälfte des Arbeitsendes einer elften erfindungsgemässen Elektrode, welche sich von der in Fig. 9 gezeigten lediglich dadurch unterscheidet, dass der metallische Leiter 1 nur im Bereich der Elektrodenspitze 8 mit der anspruchsgemässen ersten Isolationsbeschichtung 2 versehen, wobei die Elektrodenspitze 8 selbst metallisch blank ist, und in den übrigen Bereichen mit einer anspruchsgemässen zweiten Isolationsbeschichtung 4, z.B. aus PE, mit einer Permittivität kleiner 50 versehen ist. Dabei gehen die beiden Isolationsbeschichtungen 2, 4 in einem Übergangsbereich 11 ineinander über.

Fig. 12 zeigt einen Vertikalschnitt durch eine Hälfte des Arbeitsendes einer zwölften erfindungsgemässen Elektrode, welche sich von der in Fig. 11 gezeigten lediglich dadurch unterscheidet, dass der metallische Leiter 1 aus einem Isolatorkörper 3 aus einem Material mit einer Permittivität kleiner 20, z.B. aus PE oder PP, herausragt.

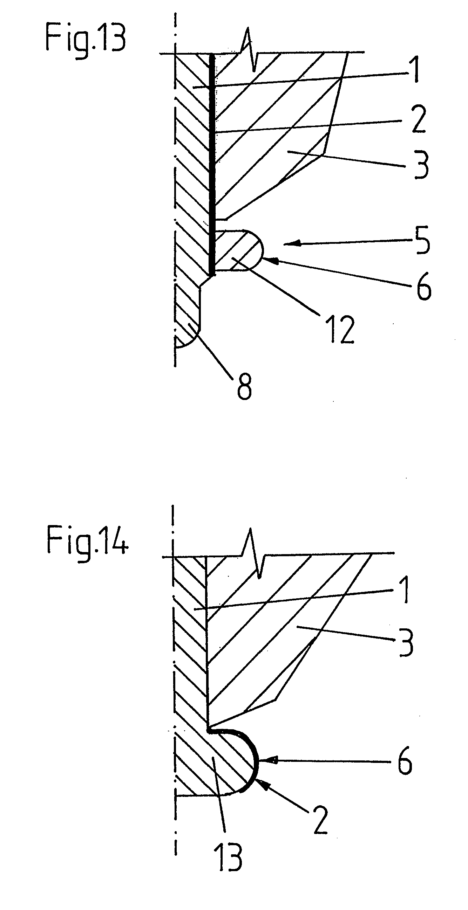

Fig. 13 zeigt einen Vertikalschnitt durch eine Hälfte des Arbeitsendes einer dreizehnten erfindungsgemässen Elektrode, welche sich von der in Fig. 10 gezeigten Elektrode lediglich dadurch unterscheidet, dass der metallische Leiter 1 zwischen Elektrodenspitze 8 und Isolatorkörper 3 einen ringförmigen Wulst 5 mit gerundetem Rand 6 trägt, aus dem gleichen Metall wie der metallische Leiter 1 oder aus einem anderen metallischen Material, welcher als Feldentlastung dient und durch die anspruchsgemässe erste Isolationsbeschichtung 2 vom metallischen Leiter 1 getrennt ist und elektrisch gegenüber diesem isoliert ist. Ein weiterer Unterschied zu der in Fig. 10 gezeigten Elektrode besteht darin, dass die gesamte Elektrodenspitze 8 metallisch blank ist. Der metallische Leiter 1 einer derartigen Elektrode lässt sich kostengünstig aus einer mit der anspruchsgemässen ersten Isolationsbeschichtung versehenen runden Metallstange herstellen, indem deren Ende abgedreht wird, zur Erzeugung der blanken Elektrodenspitze 8, und indem auf den an die Elektrodenspitze 8 anschliessenden beschichteten Bereich ein den ringförmigen Wulst 5 bildendes Bauteil 12 auf die beschichtete Metallstange aufgeschrumpft wird.

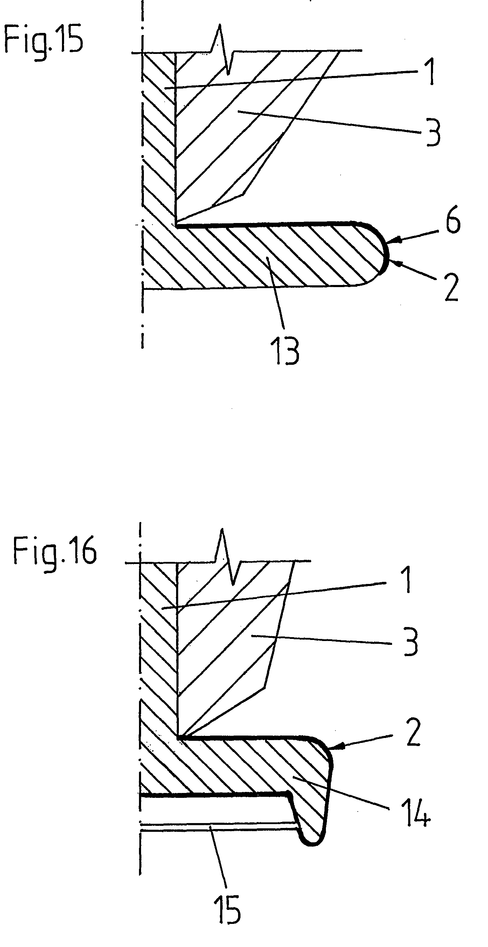

Die Figuren 14 und 15 zeigen Vertikalschnitte einmal quer (Fig. 14) und einmal längs (Fig. 15) jeweils durch eine Hälfte des Arbeitsendes einer vierzehnten erfindungsgemässen Elektrode, welche sich von der in Fig. 7 gezeigten lediglich dadurch unterscheidet, dass sie an Stelle des runden tellerförmigen Elektrodenkopfes der in Fig. 7 gezeigten Elektrode einen balkenähnlichen Elektrodenkopf 13 mit gerundetem Rand 6 aufweist.

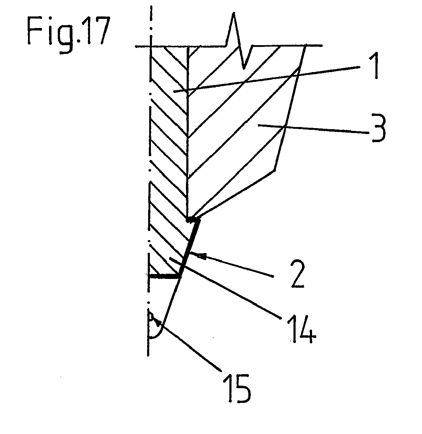

Die Figuren 16 und 17 zeigen Vertikalschnitte einmal quer (Fig. 17) und einmal längs (Fig. 16) jeweils durch eine Hälfte des Arbeitsendes einer fünfzehnten erfindungsgemässen Elektrode, welche sich von der in den Figuren 14 und 15 gezeigten lediglich dadurch unterscheidet, dass sie an Stelle des balkenähnlichen Elektrodenkopfes einen vollständig mit einer anspruchsgemässen ersten Isolationsbeschichtung 2 versehenen jochartigen Elektrodenkopf 14 aufweist, zwischen dem ein blanker Elektrodendraht 15 aufgespannt ist.

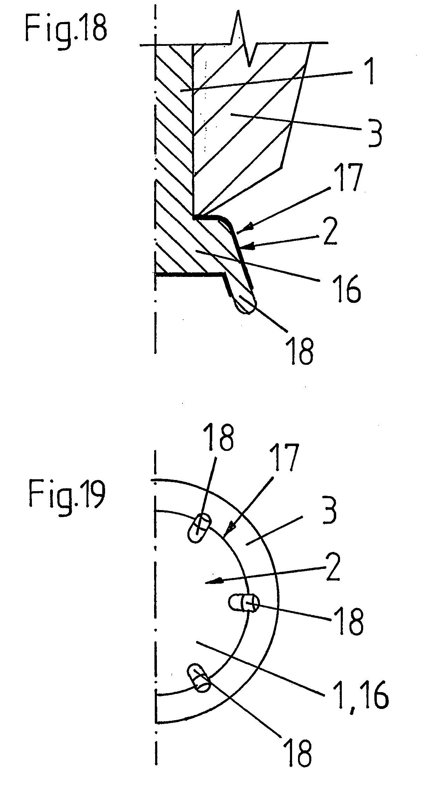

Fig. 18 zeigt einen Vertikalschnitt durch eine Hälfte des Arbeitsendes einer sechzehnten erfindungsgemässen Elektrode, welche sich von der in Fig. 7 gezeigten lediglich dadurch unterscheidet, dass sie an Stelle des runden tellerförmigen Elektrodenkopfes mit gerundetem Rand der Elektrode aus Fig. 7 einen runden tellerförmigen Elektrodenkopf 16 mit einem eine Kegelstumpfkontur beschreibenden Rand 17 aufweist, wobei an der Unterseite des Elektrodenkopfes 16 im Randbereich, gleichmässig verteilt über den Umgang desselben, sechs fingerartige Elektrodenspitzen 18 nach unten abstehen, welche leicht nach aussen geneigt sind. Die Elektrodenspitzen 18 weisen kugelkalottenförmige Stirnflächen auf. Bis auf diese Stirnflächen ist der gesamte Elektrodenkopf 16 mit einer anspruchsgemässen ersten Isolationsbeschichtung 2 versehen.

Fig. 19 zeigt eine Draufsicht auf eine Hälfte des Arbeitsendes der Elektrode aus Fig. 18.

Während in der vorliegenden Anmeldung bevorzugte Ausführungen der Erfindung beschrieben sind, ist klar darauf hinzuweisen, dass die Erfindung nicht auf diese beschränkt ist und auch in anderer Weise innerhalb des Umfangs der nun folgenden Ansprüche ausgeführt werden kann.

## Patentansprüche

1. Verfahren zur Fragmentierung und/oder Schwächung von Material, insbesondere von Gesteinsmaterial oder Erz, mittels Hochspannungspulsen, wobei das zu fragmentierende und/oder zu schwächende Material und eine Prozessflüssigkeit in einer zwischen zwei Elektroden gebildeten Prozesszone angeordnet werden, derart, dass die gesamte Prozesszone mit Prozessflüssigkeit geflutet ist, und wobei die Elektroden mit Hochspannungspulsen beaufschlagt werden, derart, dass es zwischen den beiden Elektroden zu Hochspannungsdurchschlägen kommt und/oder zur Bildung von Vorentladungskanälen ohne Durchschläge,
wobei für mindestens eine erste der beiden Elektroden eine Elektrode mit einem metallischen Leiter (1) gewählt wird, der am Arbeitsende der Elektrode, welches mit der Prozessflüssigkeit in Kontakt steht, teilweise oder vollständig mit einer ersten Isolierung, insbesondere einer ersten Isolationsbeschichtung (2) versehen ist, welche eine Permittivität aufweist, die mindestens 75% der Permittivität der Prozessflüssigkeit, welche insbesondere Wasser ist, beträgt.

2. Verfahren nach Anspruch 1, wobei eine erste Elektrode gewählt wird, deren erste Isolierung bzw. Isolationsbeschichtung (2) eine Permittivität grösser 50 aufweist, insbesondere grösser 80.

3. Verfahren nach Anspruch 2, wobei eine erste Elektrode gewählt wird, deren erste Isolierung bzw. Isolationsbeschichtung (2) eine Permittivität zwischen 60 und 100 aufweist, insbesondere zwischen 75 und 85.

4. Verfahren nach einem der vorangehenden Ansprüche, wobei eine erste Elektrode gewählt wird, welche an ihrem Arbeitsende, welches mit der Prozessflüssigkeit in Kontakt steht, teilweise oder vollständig mit der ersten Isolierung bzw. Isolationsbeschichtung (2) und teilweise mit einer zweiten Isolierung (3), insbesondere eine zweiten Isolationsbeschichtung (4) versehen ist, welche eine Permittivität kleiner 50% der Permittivität der Prozessflüssigkeit, welche insbesondere Wasser ist, aufweist, insbesondere eine Permittivität zwischen 2 und 10.

5. Verfahren nach Anspruch 4, wobei eine erste Elektrode gewählt wird, bei welcher die erste Isolierung bzw. Isolationsbeschichtung (2) und die zweite Isolierung (3) bzw. Isolationsbeschichtung (4) direkt aneinander angrenzen, ineinander übergehen oder einander durchdringen, so dass diese eine zusammenhängende, insbesondere geschlossenen Isolationsfläche bilden.

6. Verfahren nach Anspruch 5, wobei eine erste Elektrode gewählt wird, bei welcher die Permittivität der von der ersten Isolierung bzw. Isolationsbeschichtung (2) und der zweiten Isolierung (3) bzw. Isolationsbeschichtung (4) gebildeten Isolationsfläche in Richtung vom Arbeitsende wegzeigend abnehmend ist, insbesondere zumindest bereichsweise stufenlos abnehmend ist.

7. Verfahren nach einem der vorangehenden Ansprüche, wobei die Prozesszone zwischen zwei mit einem Abstand übereinander angeordneten Elektroden gebildet wird, so dass das in der Prozesszone angeordnete zu fragmentierende und/oder zu schwächende Material auf der unteren Elektrode aufliegt, wobei insbesondere die erste Elektrode als obere Elektrode verwendet wird.

8. Verfahren nach einem der vorangehenden Ansprüche, wobei eine geschlossene Prozesszone, insbesondere in einem geschlossenen Prozessgefäss, gebildet wird.

9. Verfahren nach einem der vorangehenden Ansprüche, wobei eine offene Prozesszone gebildet wird, wobei insbesondere als untere Elektrode eine Förderbandelektrode verwendet wird.

10. Elektrode zur Verwendung im Verfahren nach einem der vorangehenden Ansprüche, umfassend einen metallischen Leiter (1) der am Arbeitsende der Elektrode, welches bei bestimmungsgemässer Verwendung der Elektrode mit der Prozessflüssigkeit in Kontakt steht, teilweise oder vollständig mit einer ersten Isolierung, insbesondere einer ersten Isolationsbeschichtung (2) versehen ist, welches eine Permittivität grösser 50 aufweist, insbesondere grösser 80.

11. Elektrode nach Anspruch 10, wobei die Permittivität der ersten Isolierung bzw. Isolationsbeschichtung (2), zwischen 60 und 100, insbesondere zwischen 75 und 85 ist.

12. Elektrode nach einem der Ansprüche 10 bis 11, wobei der metallische Leiter (1) am Arbeitsende der Elektrode, welches bei bestimmungsgemässer Verwendung der Elektrode mit der Prozessflüssigkeit in Kontakt steht, teilweise mit einer zweiten Isolierung (3), insbesondere einer zweiten Isolationsbeschichtung (4) versehen ist, welche eine Permittivität kleiner 50 aufweist, insbesondere eine Permittivität zwischen 2 und 10.

13. Elektrode nach Anspruch 12, wobei die erste Isolierung bzw. Isolationsbeschichtung (2) und die zweite Isolierung (3) bzw. Isolationsbeschichtung (4) direkt aneinander angrenzen, ineinander übergehen oder einander durchdringen, derart, dass diese eine zusammenhängende, insbesondere geschlossenen Isolationsfläche bilden.

14. Elektrode nach Anspruch 13, wobei die Permittivität der von der ersten Isolierung bzw. Isolationsbeschichtung (2) und der zweiten Isolierung (3) bzw. Isolationsbeschichtung (4) gebildeten Isolationsfläche in Richtung vom Arbeitsende wegzeigend abnehmend ist, insbesondere zumindest bereichsweise stufenlos abnehmend ist.

15. Elektrode nach einem der Ansprüche 10 bis 14, wobei der metallische Leiter (1) der Elektrode am Arbeitsende einen ringförmigen Bereich (5) mit gerundetem Rand (6) bildet.

16. Elektrode nach Anspruch 15, wobei der ringförmige Bereich (5) durch die erste Isolierung bzw. Isolationsbeschichtung (2) vom metallischen Leiter (1) getrennt ist.

17. Elektrode nach einem der Ansprüche 15 bis 16, wobei der ringförmige Bereich (5) zumindest auf seinen vom Arbeitsende wegzeigenden Flächen die erste Isolierung bzw. Isolationsbeschichtung (2) aufweist.

18. Elektrode nach einem der Ansprüche 15 bis 17, wobei der ringförmige Bereich (5) das arbeitsendseitige Ende der Elektrode bildet.

19. Elektrode nach einem der Ansprüche 15 bis 17, wobei an den ringförmigen Bereich eine insbesondere kugelkalottenförmige oder rotationsparaboloidförmige Elektrodenspitze anschliesst, welche das arbeitsendseitige Ende der Elektrode bildet und insbesondere an ihrem freien Ende metallisch blank ist.

20. Elektrode nach einem der Ansprüche 10 bis 19, wobei die Elektrode einen Isolatorkörper (3) aus einem Material mit einer Permittivität kleiner 20 aufweist, aus welchem am Arbeitsende der metallische Leiter (1) heraussteht.

21. Elektrode nach Anspruch 20, wobei der Isolatorkörper (3) von einem oder mehreren konzentrisch zu dem diesen durchdringenden metallischen Leiter (1) verlaufenden ringförmigen Elementen (7) aus einem Material mit einer höheren Permittivität als das Material des Isolators (3) durchsetzt ist.

22. Elektrode nach einem der Ansprüche 20 bis 21, wobei der metallische Leiter (1) in dem Bereich, in welchem er aus dem Isolatorkörper (3) austritt, mit der ersten oder der zweiten Isolierung bzw. Isolationsbeschichtung versehen ist.

23. Vorrichtung zum Fragmentieren und/oder Schwächen von Material, insbesondere von Gesteinsmaterial oder Erz, mittels Hochspannungspulsen, insbesondere zur Durchführung des Verfahrens nach einem der Ansprüche 1 bis 9, mit zwei Elektroden, von denen zumindest eine als Elektrode nach einem der Ansprüche 10 bis 22 ausgebildet ist, wobei zwischen den beiden Elektroden eine Prozesszone gebildet ist, in welcher das zu fragmentierende und/oder zu schwächende Material und eine Prozessflüssigkeit angeordnet werden können, derart, dass die gesamte Prozesszone mit Prozessflüssigkeit geflutet ist, und wobei dabei die Elektroden mit Hochspannungspulsen beaufschlagbar sind, derart, dass es zwischen den beiden Elektroden zu Hochspannungsdurchschlägen kommt und/oder zur Bildung von Vorentladungskanälen ohne Durchschläge.

24. Vorrichtung nach Anspruch 23, wobei jede der beiden Elektroden als Elektroden nach einem der Ansprüche 10 bis 22 ausgebildet ist.

25. Vorrichtung nach einem der Ansprüche 23 bis 24, wobei die beiden Elektroden übereinander angeordnet sind, derart, dass das zu fragmentierende und/oder zu schwächende Material bei befüllter Prozesszone auf der unteren Elektrode aufliegt, und insbesondere, wobei zumindest die obere Elektrode nach einem der Ansprüche 10 bis 22 ausgebildet ist.

26. Vorrichtung nach einem der Ansprüche 23 bis 25, wobei die Prozesszone in einem insbesondere geschlossenen Prozessgefäss gebildet ist.

27. Vorrichtung nach einem der Ansprüche 23 bis 25, wobei die Prozesszone als offene Prozesszone ausgebildet ist und insbesondere, wobei die beiden Elektroden übereinander angeordnet sind und die untere Elektrode als Förderbandelektrode ausgebildet ist.

28. Verwendung der Elektrode nach einem der Ansprüche 10 bis 22 oder der Vorrichtung nach einem der Ansprüche 23 bis 27 zum Fragmentieren und/oder Schwächen von Material, insbesondere von Gesteinsmaterial oder Erz, mittels Hochspannungspulsen, insbesondere unter Durchführung des Verfahrens nach einem der Ansprüche 1 bis 9.

## Claims

1. Method for fragmenting and/or weakening material, particularly rock material or ore, by means of high voltage pulses, wherein the material to be fragmented and/or weakened and a process liquid are arranged in a process zone formed between two electrodes, in such a way that the entire process zone is flooded with process liquid, and wherein the electrodes are charged with high voltage pulses in such a way that high voltage discharges occur between the two electrodes and/or for forming pre-discharge channels without discharges,
wherein an electrode with a metallic conductor (1) is chosen for at least one of the two electrodes, which has, at the work end of the electrode which is in contact with the process liquid, partially or entirely a first insulation, particularly a first insulation coating (2), having a permittivity of at least 75% of the permittivity of the process liquid, which is particularly water.

2. Method according to claim 1, wherein a first electrode is chosen, the insulation of which or the insulation coating (2) of which, respectively, has a permittivity greater than 50, particularly 80.

3. Method according to claim 2, wherein a first electrode is chosen, the insulation of which or the insulation coating (2) of which, respectively, has a permittivity between 60 and 100, particularly between 75 and 85.

4. Method according to one of the preceding claims, wherein a first electrode is chosen, which has at its work end which is in contact with the process liquid, partially or entirely a first insulation or a first insulation coating (2), respectively, and partially a second insulation (3), particularly a second insulation coating (4), having a permittivity smaller than 50% of the permittivity of the process liquid, which is particularly water, particularly a permittivity between 2 and 10.

5. Method according to claim 4, wherein a first electrode is chosen, for which the first insulation or the first insulation coating (2), respectively, and the second insulation (3) or the second insulation coating (4), respectively, are directly neighbouring, follow one another or penetrate one another, such that they form a contiguous, particularly sealing, insulation surface.

6. Method according to claim 5, wherein a first electrode is chosen, for which the permittivity of the insulation surface formed by the first insulation or the first insulation coating (2), respectively, and the second insulation (3) or the second insulation coating (4), respectively, decreases in a direction showing away from the work end, particularly decreases continuously at least section-wise.

7. Method according to one of the preceding claims, wherein the process zone is formed between two electrodes arranged at a distance one above the other such that the material to be fragmented and/or weakened arranged in the process zone lies on the bottom electrode, wherein particularly the first electrode is used as upper electrode.

8. Method according to one of the preceding claims, wherein a closed process zone is formed, particularly in a closed process recipient.

9. Method according to one of the preceding claims, wherein an opened process zone is formed, wherein particularly a transport band electrode is used as bottom electrode.

10. Electrode for use in the method according to one of the preceding claims, comprising a metallic conductor (1) having at the work end of the electrode which is in contact with the process liquid if used as intended, partially or entirely a first insulation, particularly a first insulation coating (2), having a permittivity greater than 50, particularly greater than 80.

11. Electrode according to claim 10, wherein the permittivity of the first insulation or the first insulation coating (2), respectively, is between 60 and 100, particularly between 75 and 85.

12. Electrode according to one of the claims 10 to 11, wherein the metallic conductor (1) has at the work end of the electrode which is in contact with the process liquid if used as intended, partially or entirely a second insulation (3), particularly a second insulation coating (4), having a permittivity smaller than 50, particularly a permittivity between 2 and 10.

13. Electrode according to claim 12, wherein the first insulation or the first insulation coating (2), respectively, and the second insulation (3) or the second insulation coating (4), respectively, are directly neighbouring, follow one another or penetrate one another, such that they form a contiguous, particularly sealing, insulation surface.

14. Electrode according to claim 13, wherein the permittivity of the insulation surface formed by the first insulation or the first insulation coating (2), respectively, and the second insulation (3) or the second insulation coating (4), respectively, decreases in a direction showing away from the work end, particularly decreases continuously at least section-wise.

15. Electrode according to one of the claims 10 to 14, wherein the metallic conductor (1) of the electrode forms at the work end an annular section (5) with a rounded edge (6).

16. Electrode according to claim 15, wherein the annular section (5) is separated from the metallic conductor (1) by the first insulation or the first insulation coating (2), respectively.

17. Electrode according to one of the claims 15 to 16, wherein the annular section (5) has the first insulation or the first insulation coating (2), respectively, at least on its surfaces showing away from the work end.

18. Electrode according to one of the claims 15 to 17, wherein the annular section (5) forms the work-end-sided extremity of the electrode.

19. Electrode according to one of the claims 15 to 17, wherein the annular section (5) is followed by an electrode tip, particularly having a shape of a spherical calotte or a rotational paraboloid, which forms the work-end-sided extremity of the electrode and particularly has blank metal at its free end.

20. Electrode according to one of the claims 10 to 19, wherein the electrode has an insulation body (3) made of a material with a permittivity smaller than 20, from which the metallic conductor (1) protrudes outwards at the work end.

21. Electrode according to claim 20, wherein the insulation body (3) is penetrated by one or more annular elements (7) made of a material with a higher permittivity than the material of the insulator (3), which run concentrically with respect to the penetrating metallic conductor (1).

22. Electrode according to one of the claims 20 to 21, wherein the metallic conductor (1) has the first insulation or the second insulation or the insulation coating, respectively, in the area where it comes out of the insulation body (3).

23. Device for fragmenting and/or weakening material, particularly rock material or ore, by means of high voltage pulses, for carrying out the method according to one of the claims 1 to 9, with two electrodes, of which at least one is formed as an electrode according to one of the claims 10 to 22, wherein a process zone is formed between the two electrodes, in which the material to be fragmented and/or weakened and a process liquid can be arranged, in such a way that the entire process zone is flooded with process liquid, and wherein the electrodes are charged with high voltage pulses in such a way that high voltage discharges occur between the two electrodes and/or for forming pre-discharge channels without discharges.

24. Device according to claim 23, wherein each of the two electrodes is formed as an electrode according to one of the claims 10 to 22.

25. Device according to one of the claims 23 to 24, wherein the two electrodes are arranged one above the other such that the material to be fragmented and/or weakened lies on the bottom electrode, when the process zone is filled, and particularly wherein at least the upper electrode'is formed according to one of the claims 10 to 22.

26. Device according to one of the claims 23 to 25, wherein the process zone is formed in a particularly closed process recipient.

27. Device according to one of the claims 23 to 25, wherein the process zone is formed as opened process zone and particularly the two electrodes are arranged one above the other and a transport band electrode is used as bottom electrode.

28. Use of the electrode according to one of the claims 10 to 22 or of the device according to one of the claims 23 to 27 for fragmenting and/or weakening material, particularly rock material or ore, by means of high voltage pulses, particularly for carrying out the method according to one of the claims 1 to 9.

## Revendications

1. Procédé pour fragmenter et/ou faiblir du matériau, particulièrement du matériau rocheux ou du minerai, à l'aide des pulses de haute tension, le matériau à fragmenter et/ou à faiblir et un liquide de processus étant arrangés dans une zone de processus formée entre deux électrodes, de sorte que la zone de processus entière soit inondée avec de l'eau de processus, et les électrodes étant alimentés avec des pulses de haute tension de sorte que des décharges de haute tension se produisent entre les deux électrodes et/ou pour former des canaux de pré-décharge sans des décharges,
une électrode avec un conducteur métallique (1) étant choisi pour au moins l'une des deux électrodes, qui a, à l'extrémité de travail de l'électrode qui est en contact avec le liquide de processus, partiellement ou entièrement une première isolation, particulièrement une première couche d'isolation (2), ayant une permittivité d'au moins 75% de la permittivité du liquide de processus, qui est particulièrement de l'eau.

2. Procédé selon la revendication 1, une première électrode étant choisie, l'isolation de laquelle ou bien la couche d'isolation (2) de laquelle ayant une permittivité supérieure à 50, particulièrement 80.

3. Procédé selon la revendication 2, une première électrode étant choisie, l'isolation de laquelle ou bien la couche d'isolation (2) de laquelle ayant une permittivité comprise entre 60 et 100, particulièrement entre 75 et 85.

4. Procédé selon l'une des revendications précédentes, une première électrode étant choisie qui a à son extrémité de travail qui est en contact avec le liquide de processus, partiellement ou entièrement une première isolation ou bien une première couche d'isolation (2), et partiellement une deuxième isolation, particulièrement une deuxième couche d'isolation (4), ayant une permittivité inférieure à 50% de la permittivité du liquide de processus, qui est particulièrement de l'eau, particulièrement une permittivité comprise entre 2 et 10.

5. Procédé selon la revendication 4, une première électrode étant choisie, pour laquelle la première isolation ou bien la première couche d'isolation (2) et la deuxième isolation (3) ou bien la deuxième couche d'isolation (4), sont directement une à côté de l'autre, se suivent ou l'une pénètre l'autre, de sorte qu'elles forment une surface uniforme, particulièrement une surface d'isolation fermée.

6. Procédé selon la revendication 5, une première électrode étant choisie, pour laquelle la permittivité de la surface d'isolation formée par la première isolation ou bien la première couche d'isolation (2) et la deuxième isolation (3) ou bien la deuxième couche d'isolation (4), décroît dans une direction s'éloignant de l'extrémité de travail, particulièrement décroît de manière continue au moins par sections.

7. Procédé selon l'une des revendications précédentes, la zone de processus étant arrangée entre deux électrodes arrangées à une distance l'une au-dessus de l'autre de sorte que le matériau à fragmenter et/ou à faiblir arrangé dans la zone de processus est posé au fond de l'électrode, particulièrement la première électrode étant utilisée comme électrode supérieure.

8. Procédé selon l'une des revendications précédentes, une zone de processus fermée étant formée, particulièrement dans un récipient de processus fermé.

9. Procédé selon l'une des revendications précédentes, une zone de processus ouverte étant formée, particulièrement une électrode en forme de bande de transport étant utilisée comme électrode inférieure.

10. Électrode pour l'utilisation dans le procédé selon l'une des revendications précédentes, comprenant un conducteur métallique (1) ayant du côté de travail de l'électrode qui est en contact avec le liquide de processus, si utilisé comme prévu, partiellement ou entièrement une première isolation, particulièrement une première couche d'isolation (2), ayant une permittivité supérieure à 50, particulièrement supérieure à 80.

11. Électrode selon la revendication 10, la permittivité de la première isolation ou bien de la première couche d'isolation (2) étant comprise entre 60 et 100, particulièrement entre 75 et 85.

12. Électrode selon l'une des revendications 10 à 11, le conducteur métallique (1) ayant à l'extrémité de travail de l'électrode qui est en contact avec le liquide de processus, si utilisé comme prévu, partiellement ou entièrement une deuxième isolation (3), particulièrement une deuxième couche d'isolation (4), ayant une permittivité inférieure à 50, particulièrement une permittivité comprise entre 2 et 10.

13. Électrode selon la revendication 12, la première isolation ou bien la première couche d'isolation (2) et la deuxième isolation (3) ou bien la deuxième couche d'isolation (4), étant directement une à côté de l'autre, se suivant ou l'une pénétrant l'autre, de sorte qu'elles forment une surface d'isolation uniforme, particulièrement fermante.

14. Électrode selon la revendication 13, la permittivité de la surface d'isolation formée par la première isolation ou bien la première couche d'isolation (2) et la deuxième isolation (3) ou bien la deuxième couche d'isolation (4), décroît dans une direction s'éloignant de l'extrémité de travail, particulièrement décroît de manière continue au moins par sections.

15. Électrode selon l'une des revendications 10 à 14, le conducteur métallique (1) de l'électrode formant à l'extrémité de travail une section annulaire (5) avec un bord arrondi (6).

16. Électrode selon la revendication 15, la section annulaire (5) étant séparée du conducteur métallique (1) par la première isolation ou bien la première couche d'isolation (2).

17. Électrode selon l'une des revendications 15 à 16, la section annulaire (5) ayant la première isolation ou bien la première couche d'isolation (2) au moins sur ses surfaces dans une direction qui s'éloigne de l'extrémité de travail.

18. Électrode selon l'une des revendications 15 à 17, la section annulaire (5) formant l'extrémité du côté de l'extrémité de travail de l'électrode.

19. Électrode selon l'une des revendications 15 à 17, la section annulaire (5) étant suivie par une pointe d'électrode, particulièrement ayant une forme de calotte sphérique ou de paraboloïde de rotation, qui forme l'extrémité du côté de l'extrémité de travail de l'électrode et particulièrement qui a du métal nu à son extrémité libre.

20. Électrode selon l'une des revendications 10 à 19, l'électrode ayant un corps d'isolation (3) en un matériau avec une permittivité inférieure à 20, duquel le conducteur métallique (1) fait saille du côté de travail.

21. Électrode selon la revendication 20, le corps d'isolation (3) étant pénétré par un ou plusieurs éléments annulaires (7) en un matériau avec une permittivité supérieure à telle du matériau de l'isolateur (3), qui s'étendent de manière concentrique par rapport au conducteur métallique (1) pénétrant.

22. Électrode selon l'une des revendications 20 à 21, le conducteur métallique (1) ayant la première isolation ou bien la deuxième isolation ou bien la couche d'isolation, dans la région ou il sort du corps d'isolation (3).

23. Dispositif pour fragmenter et/ou faiblir du matériau, particulièrement du matériau rocheux ou du minerai, à l'aide des pulses de haute tension, pour exécuter le procédé selon l'une des revendications 1 à 9, avec deux électrodes, desquelles au moins une est formée comme une électrode selon l'une des revendications 10 à 22, une zone de processus étant formée entre deux électrodes, dans laquelle le matériau à fragmenter et/ou à faiblir et un liquide de processus sont arrangés, de sorte que la zone de processus entière soit inondée avec de l'eau de processus, et les électrodes étant alimentés avec des pulses de haute tension de sorte que des décharges de haute tension se produisent entre les deux électrodes et/ou pour former des canaux de pré-décharge sans des décharges.

24. Dispositif selon la revendication 23, chacun des deux électrodes étant formé comme électrode selon l'une des revendications 10 à 22.

25. Dispositif selon l'une des revendications 23 à 24, les deux électrodes étant arrangées l'une au-dessus de l'autre de sorte que le matériau à fragmenter et/ou à faiblir est posé au fond de l'électrode quand la zone de processus est remplie, et particulièrement l'électrode supérieure étant formée comme une électrode selon l'une des revendications 10 à 22.

26. Dispositif selon l'une des revendications 23 à 25, la zone de processus étant formée dans un récipient de processus particulièrement fermé.

27. Dispositif selon l'une des revendications 23 à 25, la zone de processus étant formée comme zone de processus ouverte et particulièrement les deux électrodes étant arrangées l'une au-dessus de l'autre et une électrode de bande de transport étant utilisée comme électrode supérieure.

28. Utilisation de l'électrode selon l'une des revendications 10 à 22 ou d'un dispositif selon l'une des revendications 23 à 27 pour fragmenter et/ou faiblir du matériau, particulièrement du matériau rocheux ou du minerai, à l'aide des pulses de haute tension, particulièrement pour exécuter le procédé selon l'une des revendications 1 à 9.
